# EUROPEAN PATENT APPLICATION

(11) **EP 1 650 817 A1**
(43) Date of publication of application: **26.04.2006**
(21) Application number: 04300695.6
(22) Date of filing: 20.10.2004
(51) Int. Cl.: H01L 51/10, H01L 51/40

(54) **OLED active matrix display manufactured using a specific shadow mask process**

(71) Applicant: Thomson Licensing, 92100 Boulogne-Billancourt (FR)
(72) Inventor: Haas, Gunther, 35760, Saint Grégoire (FR); Gorog, Istvan, 17603, Lancaster (US); Marcellin-Dibon, Eric, 92100, Boulogne Billancourt (FR); Browaeys, Jean-Philippe, 92800, PUTEAUX (FR)
(74) Representative: Ruellan-Lemonnier, Brigitte

(57) **Abstract**

The display apparatus comprises an active substrate embedding a plurality of sub-pixel control circuits that are each serially connected to one electroluminescent diode through a bottom diode electrode (7R, 7G, 7B) and an electroluminescent layer that is divided into primary colour blocks (8R, 8G, 8B), each covering a bottom diode electrode (7R, 7G, 7B). The position of the center of any bottom diode electrode (7A, 7B, 7C) coincides with the position of the center of a primary colour block (8R, 8G, 8B).

Such a display apparatus can be advantageously manufactured using a process where bottom diode electrodes and electroluminescent layers are deposited in a self aligned process through the same shadow mask. Higher pixel aperture and more efficient displays can be obtained.

## Description

The invention relates to active matrix electroluminescent displays.

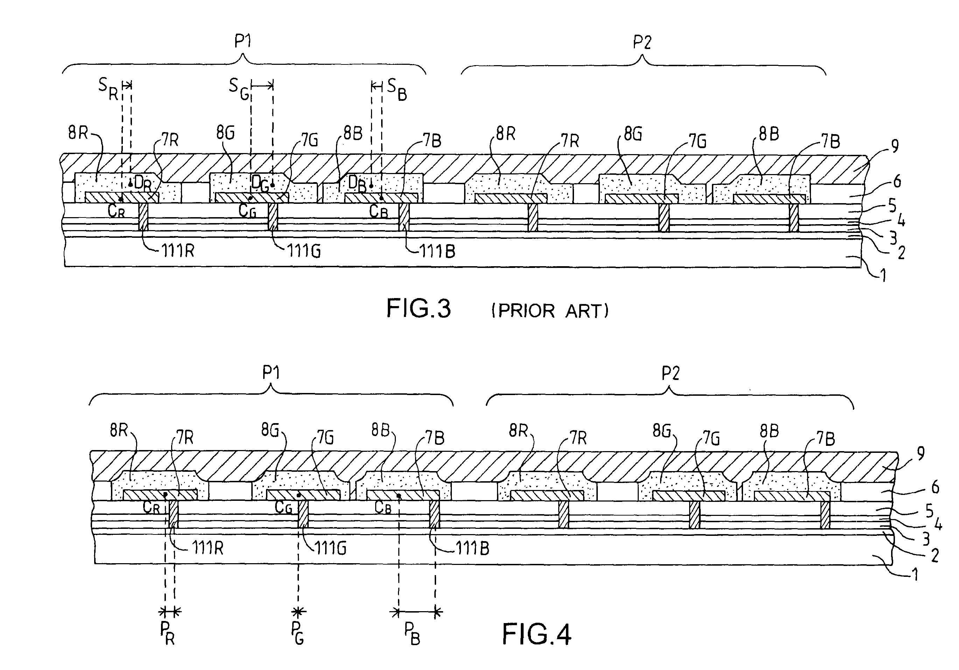

In reference to figure 3, a colour OLED display of the active matrix (AM) type, comprises generally, from bottom to top :
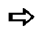 An "active" substate comprising various stacked insulating and/or dielectric layers 2, 3, 4, 5, and other metallic or semi-conducting layers, that are deposited on a ground support layer 1, e.g. a glass plate, in such a way as to realize and embed pixels circuits, one for each OLED, and networks of different lines and column electrodes to address, to control and to power all the OLEDS of the display ; each pixel circuit comprises a current modulator which is serially connected to an organic diode of the display through a bottom diode electrode 7, e.g. made of ITO or a metal;
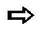 An organic electroluminescent layer 8 having a multilayer structure, comprising generally several sub-layers like hole injection layer (HIL), hole transport layer (HTL), light emissive layer (EL) which may be or not doped by a fluorescent or phosphorescent dopant, and electron transport layer (ETL), as well as, optionally, one or several thin so called blocking layers.
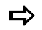 A common (or top) diode electrode 9 consisting of one or several metallic, semi conducting, or conductive oxide (like ITO or ZnO) layers. At the interface between the electroluminescent layer 8 and this top electrode, there is often a thin injection layer made of an alkali metal fluoride (e.g. LiF), in particular in case when this top electrode 9 is used for electron injection.

Optionally, an inter-pixel insulating layer 6 may be inserted, that defines the sub-pixel aperture.

Each ensemble of a bottom diode electrode 7, electroluminescent layer 8 and common electrode 9 is referred to as an organic light emitting diode (OLED) intended to display a sub-pixel of images to display, either red, green or blue ; in such a colour display, each pixel comprises several adjacent sub-pixels, one for each primary colour, e.g. red, green and blue.

Generally, the bottom diode electrodes 7 serve as the anodes, and the common top electrode 9 as the cathode, but the inverse case is also known as state of the art.

As indicated in figure 3, each pixel P1, P2 of the display comprises three adjacent sub-pixels that correspond generally to three different types of electroluminescent layers 8R, 8G, 8C that are powered respectively through the bottom electrodes 7R, 7G, 7B, which can emit light in the three respective primaries. This is achieved by choosing in particular different EL layer and different dopants for each colour, but depending on the technology the other organic sub-layers (HIL, HTL, ETL), blocking layers, or even the injection layer or other parts of the common electrode 9 may also differ according to the emission colour. The three different types of electroluminescent layers 8R, 8G, 8C are arranged in a periodic pattern as shown on figure 3 to form the so called RGB stripes. Other arrangements as so-called "Delta" arrangement are disclosed in prior art.

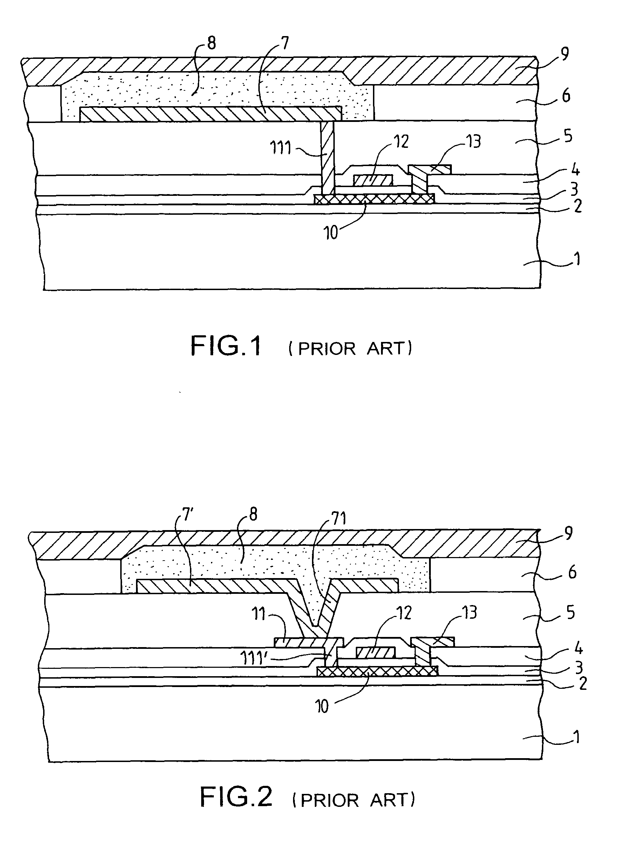

Referring to figure 1, each pixel circuit comprises generally a current modulator made of a thin film transistor (TFT), comprising a piece of semi-conductor layer 10, having a drain region and a source region with a channel and/or active region in between, and a gate electrode 12 to control the current flowing between the source and the drain, the gate being separated from the piece of semi-conducting layer 10 by an gate insulation layer 3 which is e.g. made of silicon nitride (Si₃N₄) or of silicon oxide (SiO₂). As shown on figure 1, one of the source or drain regions of the current modulator is connected to a bottom diode electrode 7 using a contact hole 111 going through the stack of one or several insulating layers 3, 4, 5. The other one of the source or drain regions of the current modulator is connected, directly or indirectly, through another contact hole 13 to a power supply electrode embedded in the active substrate (not shown).

When a current is flowing between this power supply electrode and the common top electrode 9 though the modulator and the piece of the electroluminescent layer 8 that is sandwich between the bottom diode electrode 7 and this common electrode 9, this electroluminescent layer 8 emits light and an image can be displayed.

A network of addressing or data electrodes (column electrodes) is generally embedded in the active substrate (not shown) to address the sub-pixel data voltages to the gate electrodes of the current modulators of each pixel circuits; each addressing electrode is connected to the gate electrodes of all pixel circuits that belong to the same column, through selecting switches (generally another TFT - not shown), the state of them (open or closed) are controlled by scanning electrodes (lines electrodes- not shown).

Other kinds of pixel circuits are disclosed in prior art documents and are well known in the art.

Instead of using one contact hole 111 to connect directly one of the source or drain regions of the modulator to the bottom diode electrode 7 as shown on figure 1 and as disclosed in EP1365443, US5929474 and US2003-127650 (see fig.4 and 7F), a more complex connecting mean can be used as now described in reference to figure 2 and as disclosed for example in W003-077606 (see fig.3a to 3d), US2003-111954 (see fig.3) and EP1096571.

In this type of connection, an intermediate conducting pad 11 is inserted between the current modulator and the bottom diode electrode 7, which is sandwiched between a top insulating layer 5 and an intermediate insulating layer 4. This conducting pad 11 is connected to the one of the source or drain regions of the modulator using a bottom contact hole 111', which is obviously shorter (or less deep) than the contact hole 111 of the previous embodiment. This conducting pad 11 is connected to the bottom diode electrode 7 using a top contact hole 71 which is part of the electrode layer 7. Other kind of connecting means can be used instead of usual contact holes, as disclosed for example in EP1041622 and in US6351078. Such an architecture allows to pattern the electrical circuits that connect the components of the pixel circuits on the intermediate insulating layer 4. The top insulating layer 5, or so-called "buffer" layer, is generally adapted to provide a good planarization.

The active substrate is fabricated by a standard process, as a photolithographic process as known e.g. from LCD technology, or as disclosed for OLED displays in US2002-106839, US2002-110940, US2003-127650 and EP1139453.

On this active substrate, the positions of bottom diode electrodes 7R, 7G, 7B are precisely defined within a tolerance of only few microns, a typical pixel size being between (150 to 600µm) x (50 to 200µm).

On this substrate with the bottom diode electrodes 7R, 7G, 7B, the different sub-layers of the electroluminescent layers 8R, 8G, 8C are deposited by either thermal evaporation, or by condensation from vapour phase (OPVD), or similar techniques. Unfortunately, the methods of photolithography are not applicable to OLEDs in order to create said periodic RGB structure. The commonly used method consists in a making a selective deposition though a specially patterned shadow mask, at least for the layers that differ for the R, G, and B emitting pixels. Such patterning deposition methods using shadow masks are disclosed for example in WO2004-025696, EP1207557, US5937272 and US5953587.

The process flow for depositing the electroluminescent layers 8R, 8G, 8C and the common top electrode 9 onto the active substrate can be summarized as followed :
i. Optionally: deposition of RGB-common parts of stack of sub-layers of the electroluminescent layers 8R, 8G, 8B;
ii. Using a shadow mask which is designed for one primary colour pattern, align shadow mask to red pixels;
iii. Deposition of the different sub-layers of the red electroluminescent layer 8R and, optionally, deposition of a red-specific sub-layer of the top common electrode 9;
iv. Repeat steps ii. to iii. for green and blue, after translation of the shadow mask as disclosed for example on figure 3 of US5937272 (already quoted) and on figure 4 of EP1207557 (already quoted);
v. Remove shadow mask
vi. Deposition of the common electrode 9 on the whole active surface of the display; additional common layers are generally added for encapsulation purposes.
As a variant of step iv, it is possible to use a different shadow mask for each primary colour, that requires of course positioning and alignment.

Main problems of the patterning-by-shadow-mask technique that is disclosed above are:
1. The mechanical tolerance for the position and the area of the openings in the shadow mask are related to the thickness of the latter, in practice the achievable overall tolerance is in general several tenths of microns. Additionally, there is a mismatch with respect to the photolithographically defined pattern of the bottom diode electrodes due to the alignment process, the typical precision of which is in the order of 2 to 5 µm).
2. During deposition, the shadow mask is facing the evaporation source and is therefore absorbing more heat than the substrate, thereby creating a thermal mismatch between mask and substrate. Due to the different thermal expansion coefficients of mask and substrate, this can create an additional mismatch in the order of several tenths of microns among the pixel structure on the substrate and the pixel openings on the shadow mask.
3. This overall mismatch may be different during the red, the green and the blue deposition steps, due to the lower limits or the variations of the achievable tolerance of the translation, or of the re-positioning and alignment of the shadow mask between these steps.

As shown on figure 3, problems 1., 2. and 3. above are leading to a mismatch between the precisely defined (precision typically 1µm) pattern of the bottom diode electrodes 7R, 7G, 7B that is photolithographically defined during active matrix manufacturing on one side, and the defined position of the openings in the shadow mask during the steps of deposition of the electroluminescent layers 8R, 8G, 8B on the other side. Then, as shown on figure 3, the positions of the centres D_{R}, D_{G}, D_{B} of the electroluminescent layers 8R, 8G, 8B are shifted from the positions of centres C_{R}, C_{G}, C_{B} of the bottom diode electrodes 7R, 7G, 7B, the value of the shift being respectively S_{R}, S_{G}, S_{B}
- As a consequence and in order to prevent short circuits in some sub-pixels between the bottom diode electrodes 7R, or 7G, or 7B and the common electrode 9, within each sub-pixel, the area of the electroluminescent layer 8R, or 8G, or 8B has to be far higher than the area of the corresponding bottom diode electrodes 7R, 7G, 7B, as shown on figure 3. More particularly, the difference between the width of the electroluminescent layers 8R, or 8G, or 8B and the width of the bottom diode electrodes 7R, 7G, 7B should be higher than the overall tolerance resulting from problems 1., 2. and 3. above.

Another way to prevent short circuits is disclosed in US2004-160174, which requires an additional step after bottom diode electrode deposition : an additional dielectric layer covers the edges of these electrodes.

Without such an additional insulating layer that covers the edges of these electrodes, the aperture of a sub-pixel is defined by the area of its bottom diode electrode. The relative aperture (%) of the sub-pixels is thus defined by the surface occupied by the whole bottom diode electrodes of the display apparatus divided by the overall surface of the display apparatus.

Then, the higher is the above-mentioned overall tolerance, the higher the overlap of the electroluminescent layers should be, and the lower is the overall achievable sub-pixel aperture. Typically, in such colour OLED displays of the prior art, the sub-pixel aperture is in the order of only 20% to 40%.

For a given screen luminance, this leads to a higher current density in the OLED and therefore to lower efficiency and reduced lifetime. Additionally, if the size of the substrate is increased, the shadow mask tolerances exceed the pixel size and the fabrication method becomes impracticable.

According to a preferred embodiment, the present invention overcomes the aforementioned problems by combining the following elements :
1. A self-aligned deposition by depositing the bottom diodes electrodes 7 and the electroluminescent layer 8R, 8G, 8B both through the same shadow mask, as e.g. well known for the CRT phosphor deposition and as disclosed in WO03-34471.
2. In order to avoid short circuits between the common electrode 9 and the bottom diode electrodes 7, it is proposed to have an overlap of the electroluminescent layers 8R, 8G, 8B over their corresponding bottom electrode 7. This overlap is adapted to protrude the edges of the bottom electrodes by some micrometers on its whole periphery. Such an overlap can be achieved by different methods :
   a. If OPVD is used for the deposition of the organic layer, the layer 8R, 8G, 8B will overlap the corresponding bottom electrode 7 which in any case is deposited by PVD. The overlap can be controlled by the (relatively high) base pressure of the carrier gas in the chamber. Such a method is described in W0 03-34471 (see §115 and claim 6).
   b. If PVD is used, it is proposed to achieve the overlap by slightly increasing the distance between the shadow mask and the substrate, when depositing the organic layer 8, or alternatively by increasing the geometrical etendu of the evaporation source of the organic layer with respect to that of the metal layer 7.
      Such a manufacturing process requires no translation neither removal of the shadow mask between electrodes deposition and electroluminescent layer deposition. According to usual prior art routes, this is generally not possible because active matrix are generally delivered to OLED display manufacturers with bottom diodes electrodes that are already deposited.
3. Therefore, in order to be able to deposit bottom electrodes and electroluminescent layer using the same shadow mask preferably without removal of it between the two depositions, and in order to correct for said mismatch between the precisely defined patterns of the active matrix and the less precise shadow mask pattern, the active matrix according to a preferred embodiment of the invention is provided with only relatively small contact pads instead of larger bottom diode electrodes. These pads are located around the contact holes that are made during active matrix manufacture to connect, directly or indirectly, the diodes to one of the source or the drain region of the current modulators of the active matrix. After bottom diode electrode deposition during the manufacture of the OLED display, these pads are electrically connected to these electrodes, through a direct physical contact.

Using the above-mentioned process leads to the configuration that is shown on figure 4, where the positions of the centres of the electroluminescent layers 8R, 8G, 8B are not shifted any more from the positions of the centres of the bottom diode electrodes 7R, 7G, 7B.

In order to prevent short-circuits between a bottom diode electrode and the top diode electrode, two basic variants are proposed according to the invention :
- in a first main variant, the surface of the electroluminescent layers 8R, 8G, 8B are somewhat larger (some microns at each side are sufficient) than, respectively, the surface of the bottom diode electrodes 7R, 7G, 7B. As the difference between the width of the electroluminescent layers 8R, or 8G, or 8B and the width of the bottom diode electrodes 7R, 7G, 7B can be far lower (preferably < 20 µm) than in the previous embodiment (figure 3) with the same good prevention of short circuits, higher sub-pixel apertures can be achieved.
- in a second main variant, before or/and after the deposition of the electroluminescent layers 8R, 8G, 8B using shadow masks to get the required pattern, larger intermediate organic layers or preferably a common intermediate organic layer is deposited, that is sandwiched between at least one of the bottom or top diode electrodes and the electroluminescent layers 8R, 8G, 8B themselves. This intermediate layer is adapted to inject, to transport or to bar holes or electrons. The geometry of this intermediate layer is adapted to provide an overlap over the electroluminescent layers 8R, 8G, 8B themselves in order to prevent short-circuits between the bottom diode electrode and the top diode electrode, even if the surface of the electroluminescent layers 8R, 8G, 8B themselves are not larger than, respectively, the surface of the bottom diode electrodes 7R, 7G, 7B.

When using the above-described structures and/or process, there is no mismatch any more between the positions of the bottom diode electrodes 7R, 7G, 7B and the positions of the electroluminescent layers 8R, 8G, 8B, as shown on figure 4, the mismatch problem is now transferred to the positions of the bottom electrodes of the diodes compared to the positions of the contact pads and/or contact holes 111 which connect these diodes to their corresponding sub-pixel circuit, i.e. to one of the source or drain regions of their modulator (not shown on figures 3 and 4). As a matter of fact, these contact pads and/or contact holes are positioned during the manufacture of the active matrix, far before the deposition of bottom diode electrodes. As shown on figure 4, there are high variations of the distances P_{R}, P_{G}, P_{B} between the position of the centres of the bottom diode electrodes 7R, 7G, 7B and the position of their respective contact pads and/or contact holes 111 R, 111 G, 111 B.

An object of the invention is to propose, between one of the source or drain regions of the modulators of the active matrix and the bottom electrodes of the diodes of the display, connecting means that can handle large mismatch between the positions of the pixel sub-circuits embedded into an active matrix and the positions of the organic diodes that have to be deposited on this substrate, notably when using a deposition process where ensembles of diode electrodes and electroluminescent layers are deposited in a self aligned process through the same shadow mask which is not translated neither removed between bottom electrodes deposition and electroluminescent layers deposition.

For this purpose, the subject of the invention is an image display apparatus comprising an active substrate comprising a stack of insulating and non-insulating layers, embedding a plurality of sub-pixel control circuits and supporting a plurality of organic electroluminescent diodes that are intended to display sub-pixels of the images to display,
each sub-pixel circuit comprising a current modulator that is serially connected to one of said electroluminescent diodes through a bottom diode electrode,
said image display apparatus comprising at least a top diode electrode (9) and an organic electroluminescent layer that is sandwiched between said bottom diode electrodes and said top diode electrode (9) and that is divided into groups of primary colour blocks,
characterized in that the position of the centre of any bottom diode electrode coincides with the position of the centre of a primary colour block that is part of said electroluminescent layer.

Such a coincidence of positions means that the maximum of the distance between these positions is inferior to 10 µm.

Generally, organic electroluminescent diodes are distributed on columns and lines. Preferably, there is only one common top diode electrode having a substantially uniform thickness and covering the entire active surface of the display.

Either the pattern of blocks of any given primary colour is identical to the pattern of blocks of any other primary colour, which allows using the same shadow mask for all the primary colours, either it is different, which requires a specific shadow mask for each primary colour.

The primary colour blocks are generally separated one from another and there is therefore no overlap of one block over another neighbouring one.

Preferably, according to a first main variant, each block of the electroluminescent layer overlaps its corresponding bottom diode electrode over more than 1 micrometer and less than 20 micrometers beyond the limits of this electrode on its whole periphery.

This overlap is then adapted to protrude the edges of the bottom electrodes by only some micrometers on its whole periphery. Such a limited overlap allows advantageously high sub-pixel apertures and more efficient display apparatus.

According to this first variant, preferably, there is no organic layer between the bottom diode electrodes and the organic electroluminescent layer, and no organic layer between the top diode electrode(s) and the organic electroluminescent layer. No organic layer means more precisely no organic layer having a substantially uniform thickness and covering the entire active surface of the display, even on regions that are located between the organic diodes. Each primary colour block may be made of a stack of different organic sub-layers, including organic layers that are adapted, as known in the art, for transportation, injection, and/or blocking of holes or electrons.

Preferably, according to a second main variant, the image display apparatus comprises at least one intermediate organic layer that is sandwiched between said bottom diode electrodes and said electroluminescent layer and/or that is sandwiched between said top diode electrode(s) and said electroluminescent layer, said intermediate organic layer overlapping each bottom diode electrode over more than 1 micrometer beyond the limits of this electrode on its whole periphery.

Either this organic layer has a substantially uniform thickness and covering the entire active surface of the display and forms a common intermediate organic layer, either this organic layer is divided into blocks, each block underlying or overlying a primary colour block and overlapping its corresponding bottom diode electrode over more than 1 micrometer beyond the limits of this electrode on its whole periphery.

Such overlap prevents advantageously risks of electrical short-circuits between bottom diode electrodes and top diode electrode(s), even if there is no overlap between the bottom diode electrodes and the primary colour blocks that are sandwich between these electrodes.

This intermediate organic layer may be made of a stack of different organic sub-layers. Preferably, this layer or sub-layers are adapted, as known in the art, to perform transportation, injection, and/or blocking of holes or electrons.

Preferably, for any of the first or the second or other variant, each current modulator of the image display apparatus comprises a piece of a semi-conducting layer that is sandwiched between a gate insulating layer and another insulating layer of the substrate, and that has a drain region, a source region, and an active region in between ; and each bottom diode electrode is connected to one of the drain or source regions of a modulator, through at least a contact hole having a contact pad at one end of said contact hole.

Such a contact hole penetrates at least one insulating layer covering said piece of semi-conductor layer.

Each current modulator further comprises a gate electrode that is located above or below its active region of the semiconductor layer and insulated from the semiconductor layer by the gate insulation layer. The active region is in the middle of the piece of semi-conductor layer, and the drain and source regions are disposed on both sides of this active region.

Preferably, said a contact hole has a conical shape. Such a shape is advantageous to get more secure electrical contacts.

Preferably, the sides of the contact holes make an inclination with respect to the average plane of the substrate which is less than 50°, i.e. a soft slope.

Preferably, said bottom diode electrode is in physical contact with said contact pad over the entire surface of this pad, and the area of said pad is at least five times smaller than the area of said bottom diode electrode. Said areas are evaluated on a section roughly parallel to the display apparatus.

Preferably, this contact pad is embedded within this bottom diode electrode.

Thanks to such a contact pad according to the invention, the overall mismatch between the position of the sub-pixel circuits within the active substrate and the position of the bottom electrode of the corresponding diode which is deposited on this substrate can be easily compensated.

According to the invention, the electrical contact to the sub-pixel control circuit is then ensured by connecting means having a contact pad which is part of the active substrate, which is considerably smaller than the bottom diode electrode, thus allowing to compensate a mismatch in the local periodicity and width of the openings of the shadow masks with respect to the pixel structure of the active substrate, those shadows masks which are used during the manufacture of the display apparatus.

According to a variant, each bottom diode electrode is connected to one of the drain or source regions of a modulator, through at least two contact holes, one of them having a contact pad at one end that is sandwiched between two said insulating layers. Each of these two contact holes penetrates at least one of said insulating layers.

Such an architecture allows to pattern the electrical circuits that connect the components of the pixel circuits between these two insulating layers. The top insulating layer, or so-called "buffer" layer, is generally adapted to provide a good planarization.

Preferably, in any given direction parallel to said substrate, the size of any contact pad to which a bottom diode electrode is connected through one of said two contact holes is larger that half the difference between the average size of said sub-pixels and the average distance separating adjacent bottom electrodes. Such sizes and distances are measured in the same direction.

Thanks to this geometrical criteria, the overall mismatch between the position of the sub-pixel circuits within the active substrate and the position of the bottom electrode of the corresponding diode which is deposited on this substrate can be easily compensated.

The subject of the invention is also a method to manufacture an image display apparatus according to the invention as above defined, comprising a step of deposition of some bottom diode electrodes and a step of deposition of blocks of the same primary colour on these electrodes, characterized in that the same shadow mask is used for both steps.

Preferably, the said shadow mask in not removed between the two said steps.

The subject of the invention is also a method to manufacture an image display apparatus according to the invention as above defined with overlap, comprising a first step of deposition of some bottom diode electrodes and a second step of deposition of blocks of the same primary colour on these electrodes, characterized in that
- the same shadow mask is used for both steps;
- said depositions are performed by a PVD method;
- said overlap is obtained either by increasing the distance between the shadow mask and the substrate for the second step compared to the first step, either by increasing the geometrical etendu of an evaporation source that is used to get said primary colour blocks during the second step with respect to the geometrical etendu of an evaporation source that is used to get said bottom diode electrodes during the first step.

Preferably, the said shadow mask in not removed between the two said steps.

As a summary, the subject of the invention is a display apparatus comprising an active substrate embedding a plurality of sub-pixel control circuits that are each serially connected to one electroluminescent diode through a bottom diode electrode and an electroluminescent layer that is divided into primary colour blocks, each covering a bottom diode electrode, where the position of the centre of any bottom diode electrode coincides with the position of the centre of a primary colour block.

The invention will be more clearly understood on reading the description which follows, given by way of non-limiting example and with reference to the appended figures in which:
- Figures 1 to 2, already mentioned, show sections of one sub-pixel of two different types of active matrix OLED displays according to the prior art;
- Figure 3, already mentioned, show a larger section of two adjacent pixels, each comprising three sub-pixels, of the two different types of active matrix OLED displays according to the prior art that are shown on figures 1 and 2;
- Figure 4 shows a larger section of two adjacent pixels according another embodiment of an active matrix OLED display;
- Figures 5 and 6 show sections of one sub-pixel of an active matrix

OLED display according to two different embodiments of the invention.

The figures take no account of the scale of values so as to better reveal certain details, which would not be clearly apparent if the proportions had been respected.

To simplify the description and demonstrate the differences and advantages that the invention has over the prior art, identical references will be used for the elements which provide the same functions.

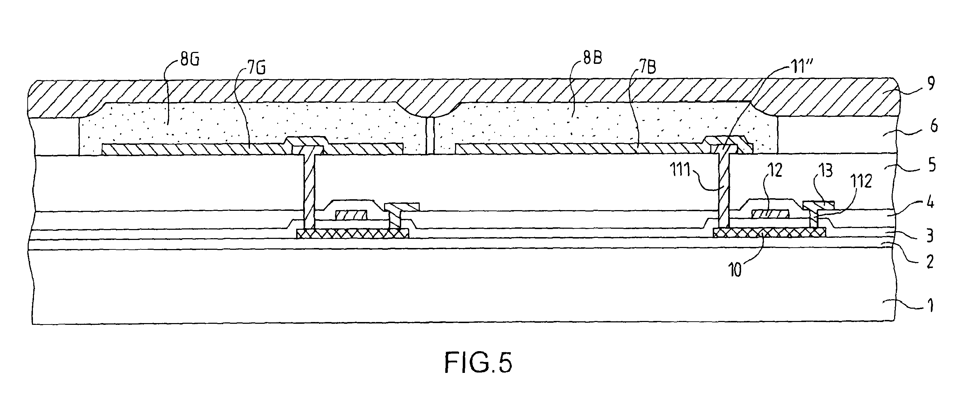

Reference will now be made in detail to a first embodiment of the present invention, example of which is illustrated by figures 5 and 4.

Figure 5 is a schematic cross-sectional view of a sub-pixel of an active matrix OLED display of this embodiment. Since the active matrix uses a p-Si thin film transistor, a top gate type structure is adopted, although a bottom gate may have been adapted without departing from the invention.

In figure 5, a bottom buffer layer 2 is formed on entire surface of a ground support layer 1, e.g. a glass plate. This bottom buffer layer 2 may be made of silicon nitride or silicon oxide. A semiconductor layer 10 that has an island-shape is formed of polycrystalline silicon on the bottom buffer layer 2. Each island of this semiconductor layer 10 is divided into a central active region to which dopant is not applied and drain and source side regions to which the dopant is applied and doped. Here, the bottom buffer layer 2 prevents that the impurities infiltrating from the glass plate. A gate insulation layer 3 is formed on the bottom buffer layer 2, covering the active, drain and source regions. A gate electrode 12 is formed on the gate insulation layer 3 above the active region of each island of the polycrystalline semiconductor layer 10. The gate electrodes 12 may be formed right above these active regions. Then, an interlayer insulator layer 4 is disposed on the gate insulation layer 3, covering the gate electrodes 12. Meanwhile, a first contact hole 112 which penetrates both the interlayer insulating layer 4 and the gate insulation layer 3, is provided to contact the drain regions of each island of the semi-conductor layer 10. Other contact holes or circuitry may be provided, depending on the sub-pixel circuit to embed. A drain electrode 13, which is made of an opaque conductive material, such as metal, is disposed on the interlayer insulating layer 4. Then, a top insulating layer 5 is formed on the interlayer insulating layer 4, covering the drain electrodes 13. Then, a second contact hole 111 which penetrates the top insulating layer 5, the interlayer insulating layer 4 and the gate insulation layer 3, is provided with a contact pad 11" to contact the source regions of each island of the semi-conductor layer 10. The contact pad 11" is then disposed on the top insulating layer 5. The active matrix substrate of the OLED display is thus obtained.

On this active substrate, diode electrodes and electroluminescent layers are deposited using a shadow mask that is patterned both to form diode electrodes and to form primary colour blocks electroluminescent layers, according to the following process flow:
i. Align the adapted patterned shadow mask to red sub-pixels
ii. Deposition of bottom red diode electrodes 7R through shadow mask.
iii. Slightly increase distance shadow mask to substrate by an amount δ (few µm), or use an evaporation source at a shorter equivalent distance from substrate as in ii.
iv. Deposition of red blocks 8R through the same shadow mask as in step ii to form a patterned red electroluminescent layer, and optionally, deposition of a red-specific sub-layer of common electrode 9.
v. Align the same or another adapted shadow mask to green pixels and reduce distance mask to substrate by δ, or use deposition source at larger equivalent distance from substrate as iii.
vi. Repeat steps i. to v. for green and blue using preferably the same shadow mask.
vii. Remove shadow mask
viii. Deposition of common electrode 9 (or common part of it)
The deposition (ii) of the bottom diode electrodes 7R, 7G, 7B can be either by sputtering (e.g. in case of ITO or metals), thermal evaporation (in case of metals) or any other method. The same applies for the deposition of the common electrode, step (viii).

It has to be pointed out that when using such a process, each primary colour stripe of the electroluminescent layer is divided into a group of blocks of the same primary colour, each block being separated from its neighbour.

As shown on figure 4, the position of the centre of each bottom diode electrode 7A, 7B, 7C coincides with the position of the centre of a primary colour block 8R, 8G, 8B that is part of the electroluminescent layer. Such a coincidence of positions means that the maximum of the distance between these coincidal positions is inferior to about 5 µm to 10 µm.

In a first variant, the same shadow mask can be used for the different primary colours, leading moreover to the same patterns for the red bottom electrodes 7R, for the green bottom electrodes 7G, and for the blue bottom electrodes 7B, leading also to the same pattern for the red blocks 8R, for the green blocks 8G, and for the blue blocks 8B. Such an identical pattern for the different primary colours allows advantageously a simple translation between the repetitions of the steps i. to v. , then avoids time consuming alignment steps, and allows a more precise patterning. During the process of depositions on the active substrate, ensembles of diode electrodes and electroluminescent layers are then deposited in a self aligned process through the same shadow mask which is not translated neither removed between electrodes deposition (step ii) and electroluminescent layers deposition (step iv) of a given primary colour.

In a second variant, different shadow masks are used for the different primary colours, allowing different pixel patterns and/or areas according to the primary colour.

According to a first main variant to prevent short circuits between bottom diode electrodes 7R, 7G, 7B and the common electrode 9, each blocks 8R, 8G, 8B of the electroluminescent layer should overlap a few micrometers the corresponding bottom diode electrode 7R, 7G, 7B. Consequently, each blocks 8R, 8G, 8B of the electroluminescent layer extends beyond the limits of its corresponding bottom diode electrode 7R, 7G, 7B, preferably more than one micrometer and less than twenty micrometers. Such a limited overlap (less than twenty micrometers) allows advantageously high sub-pixel apertures and more efficient display apparatus.

To get such electroluminescent layers 8R, 8G, 8B that are a little larger that the corresponding bottom diode electrodes 7R, 7G, 7B as shown on figures 5 and 4, what is required to avoid short-circuits has previously been explained in reference to WO03-34471. But instead of using different deposition processes as disclosed in WO03-34471 for electrode deposition and for electroluminescent layer deposition, the same effect is obtained according with the invention by slightly increasing the distance between mask and substrate (few µm) when depositing the electroluminescent layers.

Alternatively, the distance between the mask and the substrate is kept constant at a distance d between 1 and 50 µm. This can be achieved by having spacers of a suitable thickness either on the mask or on the substrate. In the latter case, the spacer may e.g. consist of a photoresist structure, or of µ-balls as used in LCD technology. In general the mask is pressed on the substrate by magnetic force thus ensuring a constant distance d.

The so-called "equivalent distance" between evaporation source and the ensemble of substrate takes into account the geometrical etendu and the lateral velocity components of the particles between two evaporating sources that may be different with respect to these aspects, e.g. the source for the bottom diode electrodes may be a sputtering source, and the source for the electroluminescent layers may be a thermal evaporation source. For the deposition of the electroluminescent layers, this equivalent distance between evaporation source and the ensemble of substrate and mask is decreased with respect to the equivalent distance when depositing the bottom diode electrodes, ensuring that the lateral extension of the electroluminescent layers exceeds that of the bottom diode electrodes as required to avoid shorts.

Through the increased distance between mask and substrate (or the decreased equivalent deposition distance) when depositing the organic stack, the lateral dimensions of the latter exceed the dimensions of the pixel electrode by an overlap Δ, preventing from shorts between pixel electrode and common electrode. Depending on the lateral conductivity of the organic electroluminescent layers 8R, 8G, 8B, the overlap Δ will be chosen such as to prevent considerable leakage current across the edge of the pixel. As the said lateral conductivity of the organic electroluminescent layers is in general low due to its low overall thickness of around 50 - 100nm, Δ can be chosen rather small, a few microns are generally sufficient.

According to a second main variant to prevent short circuits between bottom diode electrodes 7R, 7G, 7B and the common electrode 9,
the following method is applied: if the electroluminescent layers 8R, 8G, 8B form central and emissive layers, such emissive layers are sandwiched between, on one side, a common organic hole injection and/ or organic hole transport layers, and, on the other side, a common organic electron injection and/or organic electron transport layers, said common layers covering a surface larger than the the surface of the bottom diode electrodes 7R, 7G, 7B, preferably even covering the whole active area. In this case, near the border of each electroluminescent diode, these common layers protect against short circuits by forming a P-N junction (in absence of the emissive layer) with similar current-voltage characteristics as the OLED. In this preferred embodiment, the shadow mask has to be removed after deposition of the bottom diode electrodes 7R, 7G, 7B, and to be realigned before depositing the emissive central part of the electroluminescent layers 8R, 8G, 8B. On the other hand, all patterns generated by the shadow mask have the same size, so the distance between shadow mask and substrate or the etendu of the evapotation source as described before remain unchanged.

According to the invention, as shown above, there is no substantial mismatch between the local periodicity of the array of primary colour blocks 8R, 8G, 8B and the local periodicity of the array of bottom diode electrodes 7R, 7G, 7B. But, on the contrary, there is generally a mismatch between the local periodicity of the array of contact pads 11" and the array of bottom diode electrodes 7R, 7G, 7B, resulting, as shown on figure 4, in high variations of the distances P_{R}, P_{G}, P_{B} between the position of the centres of the bottom diode electrodes 7R, 7G, 7B and the position of the centres of the respective contact pads 11" that are located at one end of the contact holes 111 R, 111 G, 111 B.

But, for steps i above, whatever is the mismatch between the position of an opening of the mask corresponding to a bottom diode electrode 7R, 7G, 7B to be deposited and the position of the contact pad 11" that this bottom diode electrode must contact, after deposition, the deposited bottom electrode 7R, 7G, 7B covers at least partially and preferably totally the contact pad 11" as shown on figure 5, in order to ensure an electric contact.

As shown on the figure 5, to be able to compensate this mismatch, the area of the covered contact pad 11" is far smaller, preferably at least five times, than the area of the covering bottom diode electrode 7R, 7G, 7B. According to the invention, the electrical contact between the output of the sub-pixel circuit and the corresponding diode is then ensured by a contact pad 11" which is part of the active substrate, which is considerably smaller than the bottom diode electrode, thus allowing to compensate a mismatch in the local periodicity and width of the openings of the shadow masks with respect to the pixel structure of the active substrate.

To allow compensation of larger mismatches, i.e. higher variations of the distances P_{R}, P_{G}, P_{B} between the position of the centres of the bottom diode electrodes 7R, 7G, 7B and the position of the centres of the respective contact pads 11 ", it is preferred that the average of said distances is lower than 10% of the average size of said electrodes in the same direction as that of these distances. It means that, in average, the contact pads 11" are preferably and in average centred on their corresponding bottom diode electrodes 7R, 7G, 7B.

The image display apparatus according to the first embodiment of the invention is thus obtained.

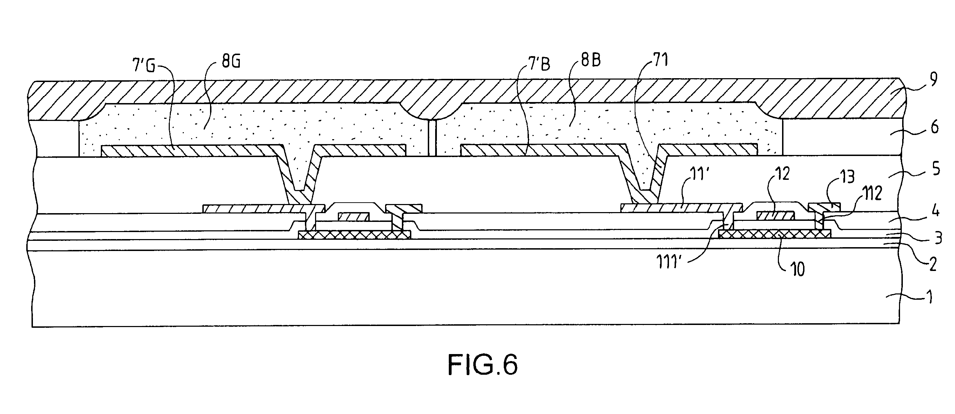

Reference will now be made in detail to a second embodiment of the present invention, example of which is illustrated by figures 6 and 4. Figure 6 is a schematic cross-sectional view of a sub-pixel of an active matrix OLED display of this embodiment.

In figure 6, a bottom buffer layer 2, a semiconductor layer 10, a gate insulation layer 3, gate electrodes 12, and a interlayer insulating layer 4 are formed as in the first embodiment on the same ground support layer 1.

Meanwhile, a first contact hole 112 and a second contact hole 111' which penetrates both the interlayer insulating layer 4 and the gate insulation layer 3, are provided to contact respectively the drain regions and the source regions of each island of the semi-conductor layer 10. The first contact hole 112 and the second contact hole 111' are respectively provided with a contact pad 11' and a contact pad 13, which are disposed at one end of these contact holes on the interlayer insulating layer 4. Then, a top insulating layer 5 is formed on the interlayer insulating layer 4, covering the contact pads 11', 13. During a last step, conical holes are etched that penetrate the top insulating layer up to each contact pads 11. The active matrix substrate of the OLED display is thus obtained.

On this active substrate is then applied the same following process flow as already described for the 1^{st} embodiment . During each deposition step 2 of bottom diode electrodes, conical contact holes 71 are obtained that connect each bottom diode electrode to a contact pad 11'.

The image display apparatus according to the second embodiment of the invention is thus obtained. The same advantages are obtained.

One advantage of this second embodiment over the first embodiment lies in the manufacture of the active matrix. In the second embodiment, the contact pad 11' and the drain electrode 13 are disposed on the same insulating layer 4, as in the first embodiment, the contact pad 11" and the drain electrode 12 are disposed on different insulating layers, respectively 5 and 4. Consequently, in the second embodiment, contact holes 111' and 112 can be advantageously provided during the same manufacturing step, as, on the contrary, contact holes 111 and 112 have to be provided during different manufacturing steps (then requiring two different alignment sequences), because an insulating layer 5 must be deposited between these steps. Then, manufacturing an active substrate according to the second embodiment is easier than manufacturing an active substrate according to the first embodiment.

While the present invention is described with respect to preferred embodiments, it is understood that the present invention is not limited to these embodiments. The present invention as claimed therefore includes variations from the particular examples and preferred embodiments described herein, as will be apparent to one of skill in the art. While some of the specific embodiments may be described and claimed separately, it is understood that the various features of embodiments described and claimed herein may be used in combination.

The invention will enable advantageously image display apparatus based on OLEDs that show better efficiency and higher lifetime. The displays can be produced on large substrates thus reducing the cost.

## Claims

1. An image display apparatus comprising an active substrate comprising a stack of insulating (1, 2, 3, 4, 5) and non-insulating layers, embedding a plurality of sub-pixel control circuits and supporting a plurality of organic electroluminescent diodes that are intended to display sub-pixels of the images to display,
each sub-pixel circuit comprising a current modulator that is serially connected to one of said electroluminescent diodes through a bottom diode electrode (7R, 7G, 7B; 7'R, 7'G, 7'B),
said image display apparatus comprising at least a top diode electrode (9) and an organic electroluminescent layer that is sandwiched between said bottom diode electrodes (7R, 7G, 7B; 7'R, 7'G, 7'B) and said top diode electrode (9) and that is divided into groups of primary colour blocks (8R, 8G, 8B),
**characterized in that** the position of the centre of any bottom diode electrode (7A, 7B, 7C) coincides with the position of the centre of a primary colour block (8R, 8G, 8B) that is part of said electroluminescent layer.

2. An image display apparatus according to claim 1 **characterized in that** each block (8R, 8G, 8B) of the electroluminescent layer overlaps its corresponding bottom diode electrode (7R, 7G, 7B) over more than 1 micrometer and less than 20 micrometers beyond the limits of this electrode on its whole periphery.

3. An image display apparatus according to claim 2 **characterized in that** there is no organic layer between the bottom diode electrodes and the organic electroluminescent layer, and no organic layer between the top diode electrode(s) and the organic electroluminescent layer.

4. An image display apparatus according to claim 1 **characterized in that** it comprises at least one intermediate organic layer that is sandwiched between said bottom diode electrodes and said electroluminescent layer and/or that is sandwiched between said top diode electrode(s) and said electroluminescent layer, said intermediate organic layer overlaping each bottom diode electrode over more than 1 micrometer beyond the limits of this electrode on its whole periphery.

5. An image display apparatus according to any one of claims 1 to 4, whereas each current modulator comprises a piece of a semi-conducting layer (10) that is sandwiched between a gate insulating layer (3) and another insulating layer (2) of the substrate, and that has a drain region, a source region, and an active region in between, **characterized in that** each bottom diode electrode (7A, 7B, 7C) is connected to one of the drain or source regions of a modulator, through at least a contact hole (111, 111') having a contact pad (11 ", 11') at one end of said contact hole.

6. An image display apparatus according to claim 5 **characterized in that** said a contact hole (111, 111') has a conical shape.

7. An image display apparatus according to claim 5 or 6 **characterized in that** said bottom diode electrode (7A, 7B, 7C) is in physical contact with said contact pad (11 ") over the entire surface of this pad, and that the area of said pad (11") is at least five times smaller than the area of said bottom diode electrode (7R, 7G, 7B).

8. An image display apparatus according to claim 5 **characterized in that** each bottom diode electrode (7A, 7B, 7C) is connected to one of the drain or source regions of a modulator, through at least two contact holes (71, 111'), one (111') of them having a contact pad (11') at one end that is sandwiched between two said insulating layers (4, 5).

9. An image display apparatus according to claim 8 **characterized in that**, in any given direction parallel to said substrate, the size of any contact pad (11') to which a bottom diode electrode (7R, 7G, 7B) is connected through one (71) of said two contact holes is larger that half the difference between the average size of said sub-pixels and the average distance separating adjacent bottom electrodes.

10. Method to manufacture an image display apparatus according to any one of preceding claims, comprising a step of deposition of some bottom diode electrodes (7R; 7G; 7B) and a step of deposition of blocks of the same primary colour (8R; 8G; 8B) on these electrodes, **characterized in that** the same shadow mask is used for both steps.

11. Method to manufacture an image display apparatus according to claim 10, **characterized in that** the said shadow mask in not removed between the two said steps.

12. Method to manufacture an image display apparatus according to any one of claims 2 to 9, comprising a first step of deposition of some bottom diode electrodes (7R; 7G; 7B) and a second step of deposition of blocks of the same primary colour (8R; 8G; 8B) on these electrodes, **characterized in that**
- the same shadow mask is used for both steps;
- said depositions are performed by a PVD method;
- said overlap is obtained either by increasing the distance between the shadow mask and the substrate for the second step compared to the first step, either by increasing the geometrical etendu of an evaporation source that is used to get said primary colour blocks during the second step with respect to the geometrical etendu of an evaporation source that is used to get said bottom diode electrodes during the first step.

13. Method to manufacture an image display apparatus according to claim 12, **characterized in that** the said shadow mask in not removed between the two said steps.
